Europäisches Patentamt

European Patent Office

Office européen des brevets

(11) Publication number: **0 310 353**
A2

# EUROPEAN PATENT APPLICATION

(21) Application number: 88308983.1

(22) Date of filing: 28.09.88

(51) Int. Cl.4: **H 01 L 31/10**
H 01 L 31/08

(30) Priority: 29.09.87 US 102077

(43) Date of publication of application:
05.04.89 Bulletin 89/14

(84) Designated Contracting States: **DE FR GB**

(71) Applicant: **XEROX CORPORATION**
**Xerox Square - 020**
**Rochester New York 14644 (US)**

(72) Inventor: **Hack, Michael**
**400 Del Medio No. 5**
**Mountain View California 94040 (US)**

(74) Representative: **Goode, Ian Roy et al**
**Rank Xerox Limited Patent Department 364 Euston Road**
**London NW1 3BL (GB)**

(54) High gain thin film sensor.

(57) A thin film sensor (30) having one or more blocking layers (40) disposed within an intrinsic amorphous semiconductor bulk (38, 42) sandwiched by injecting semiconductor layers (36, 44). The blocking layer of layers serve to suppress dark current while allowing light current to flow. The sensor exhibits a photoelectric gain greater than 3 and a corresponding light-to-dark ratio greater than 30 to 1.

FIG. 2

EP 0 310 353 A2

## Description

## HIGH GAIN THIN FILM SENSOR

This invention relates to a multilayer thin film sensor comprising a pair of injecting contact semiconductor layers sandwiching plural intrinsic semiconductor layers.

Thin film semiconductor materials have recently become viable materials for use in low cost, large area electronic applications. Their attractive electronic characteristics, coupled with the relative simplicity of their fabrication techniques enable the formation of active and passive devices as well as bus and address lines on a single, page size and larger, substrate. Materials such as amorphous silicon, polycrystalline silicon, microcrystalline silicon, and alloys of all these materials are now being used in these applications. While the present invention will be described with reference to amorphous silicon, it should be understood that other thin film semiconductor materials may be used with similar, if somewhat different, results.

In general, there are two main classes of photodetectors. Primary photocurrent devices, i.e., photovoltaic devices, such as p-i-n solar cells, whose output current is limited to that which is internally generated, can achieve no more than unity optical gain, exhibit high light-to-dark sensitivity, and have fast response times (on the order of less than 1 microsecond for amorphous silicon). By contrast, most secondary photocurrent devices, i.e., photoconductive devices, such as n-i-n diodes, whose output current is light enhanced and is a multiple of that which is internally generated, can achieve a high optical gain, although they exhibit low light-to-dark sensitivity and slow response times (on the order of milliseconds). A more useful sensor should have the high gain associated with photoconductive devices and the high light-to-dark sensitivity and fast response time associated with photovoltaic devices.

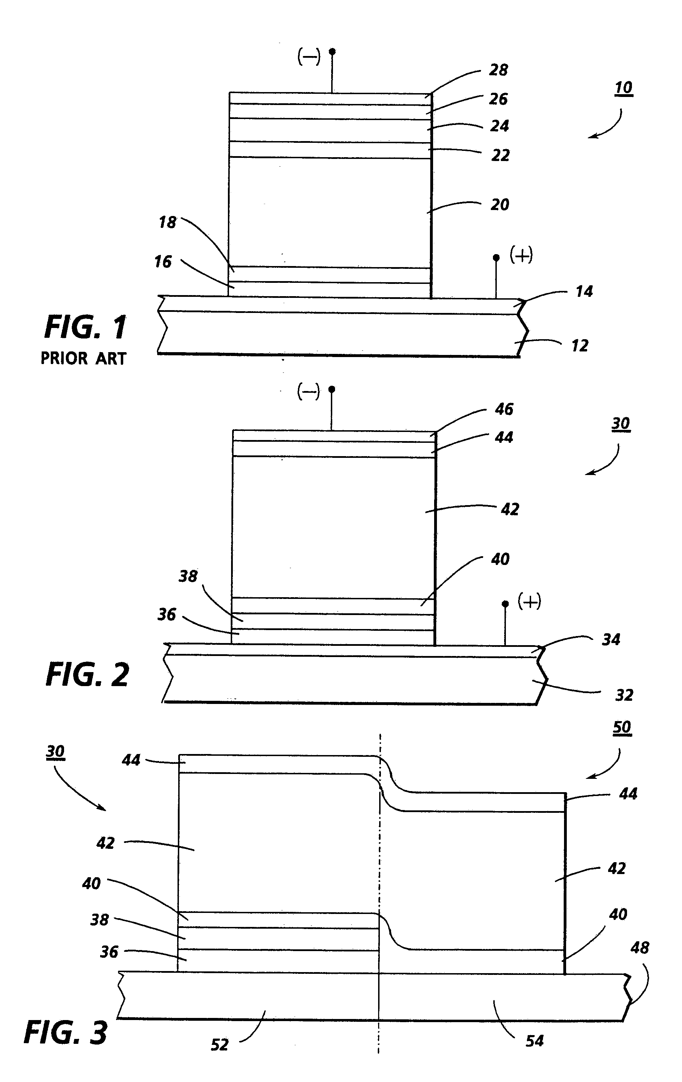

In a number of recent papers by C. Y. Chang et al there is described a sensor referred to by the authors as an n⁺-i-p⁺-i-n⁺ amorphous silicon thin film bulk barrier phototransistor. Two representative articles are **"Amorphous Silicon Phototransistor on a Glass Substrate"**, authored by B. S. Wu, C. Y Chang, Y. Y. Fang and R. H. Lee, IEEE Transactions on Electron Devices Vol. ED-32, No. 11, November 1985 and **"Photogeneration and Recombination in a Bulk Barrier Phototransistor"**, authored by C. Y. Chang, IEEE Transactions on Electron Devices, Vol. ED-33, No. 11, November, 1986. The device reported therein is illustrated in Figure 1, and will be referred to herein as the Chang phototransistor 10. It is a multilayer structure made on an insulating glass substrate 12 over which there is an ITO (indium tin oxide) conductive layer 14, and includes a collector comprising an n⁺ layer 16, and n layer 18, a thick intrinsic semiconductor layer 20, a heavily doped (p⁺) base layer 22, a thin intrinsic semiconductor layer 24, and a n⁺ emitter layer 26 over which there is an aluminum contact layer 28. In normal operation, the emitter is negatively biased with respect to the collector so that a forward bias is established across the emitter-intrinsic-base portion (26-24-22) and a reverse bias is established across the base-intrinsic-collector portion (22-20-18/16). In describing the operation of their device, the authors ascribe as the function of the heavily doped base the establishing of a high barrier to the flow of electrons, under normal bias conditions, which barrier is modulated downwardly when the device is illuminated. They assert that the phenomenon of barrier reduction results in a high gain.

The Chang phototransistor has been duplicated and it has been observed both experimentally and by computer simulation that no gain is achieved in that device except at very high applied voltage values, relative to device thickness, where the electrical field is close to breakdown. Furthermore, at these very high negative voltage levels the optical gain is small and the light-to-dark sensitivity is extremely poor, so that any sensor applications are impractical.

It is the primary object of this invention to provide a novel, thin film sensor and to operate it in such a way as to achieve the high gain associated with photoconductive devices and the high light-to-dark sensitivity and fast response time approaching that of photovoltaic devices.

These objectives may be accomplished, in one form, by providing a multilayer thin film sensor comprising a pair of injecting contact semiconductor layers sandwiching plural intrinsic semiconductor layers characterised by barrier means means therein for suppressing dark current flow and allowing high current flow so that said sensor exhibits a photoelectric gain greater than 3 and a corresponding light-to-dark ratio greater than 30 to 1.

The injecting contacts (n⁺ for amorphous silicon) sandwich a bulk of intrinsic amorphous thin film semiconductor within which there is one or more barrier layers whose purpose is to suppress dark current while having very little or no effect on light current, thereby allowing the gain and the light-to-dark sensitivity to be high. In an n-i-p-i-n embodiment, a lightly doped p-type semiconductor layer is located between intrinsic semiconductor layers of different thicknesses so that when the thin n-i-p portion is reverse biased and the thick n-i-p portion is forward biased a photoelectric gain greater than 3 and a corresponding light-to-dark ratio of greater than 30 to 1 is exhibited.

Other objects and further features and advantages of this invention will be apparent from the following description, considered with the accompanying drawings, wherein:

Figure 1 is a schematic cross-sectional view of the Chang phototransistor shown biased for normal operation.

Figure 2 is a schematic cross-sectional view of the device of the present invention shown biased for normal operation.

Figure 3 is a schematic cross-sectional view of the device of the present invention side-by-side with a solar cell for readily calculating gain,

Figure 4 is a plot showing experimental I-V curves for the device of the present invention and an adjacent solar cell under light and dark conditions,

Figure 5 is a plot showing experimental I-V curves for the Chang phototransistor and an adjacent solar cell under light and dark conditions, and

Figure 6 is a plot showing experimental I-V curves for a different Chang phototransistor over an extended range of negative voltage levels.

The sensor device of the present invention, to which the name "photoconductive diode (PCD)" has been applied, is illustrated in Figure 2. It comprises a multilayer structure 30 formed upon a glass substrate 32 overcoated with a conductive ohmic contact layer 34, such as aluminum or chromium. A typical amorphous silicon thin film PCD device 30 includes an $n^+$ emitter layer 36, a thin intrinsic amorphous silicon layer 38, a p-type (lightly doped) base layer 40, a thick intrinsic amorphous silicon layer 42, and an $n^+$ collector layer 44. Overlying the multilayer sensor is a transparent, conductive, anti-reflection top layer 46 (preferably of ITO), for optically coupling the device to the air. In normal operation of this device, the emitter 36 is positively biased with respect to the collector 44 so that a reverse bias is established across the emitter-intrinsic-base (36-38-40) portion and a forward bias is established across the base-intrinsic-collector (40-42-44) portion. It should be understood that the sensor of the present invention may be made of other suitable semiconductor materials.

For ease in directly obtaining a reliable indication of optical gain, the PCD 30 is formed side-by-side, upon a single substrate 48 with a p-i-$n^+$ solar cell 50, having substantially unity gain, as illustrated in Figure 3. Fabrication of this dual sample is extremely simple since it merely requires the masking of the substrate into two regions, namely, a sensor region 52 and a solar cell region 54, and the independent sequential deposition of the $n^+$ emitter layer 36 and the thin intrinsic layer 38 only on the sensor region 52. Then the p-type base layer 40, the thick intrinsic layer 42 and the $n^+$ collector layer 44 are deposited over both regions 52 and 54. When the dual sample is illuminated in a suitable fixture, such as a black box, direct comparison of the two devices is made possible. Since it is well known that the gain of such a solar cell device is nominally unity, comparison of the current output of the two devices gives an indication of the optical gain multiple, if any, of the sensor. Of course, it is recognized that since the thicknesses of the samples are not the same, there will be a slight variation in output current. Nevertheless, this technique is quite satisfactory for the purpose of comparing different sensors. A similar dual sample was used with the Chang Phototransistor 10.

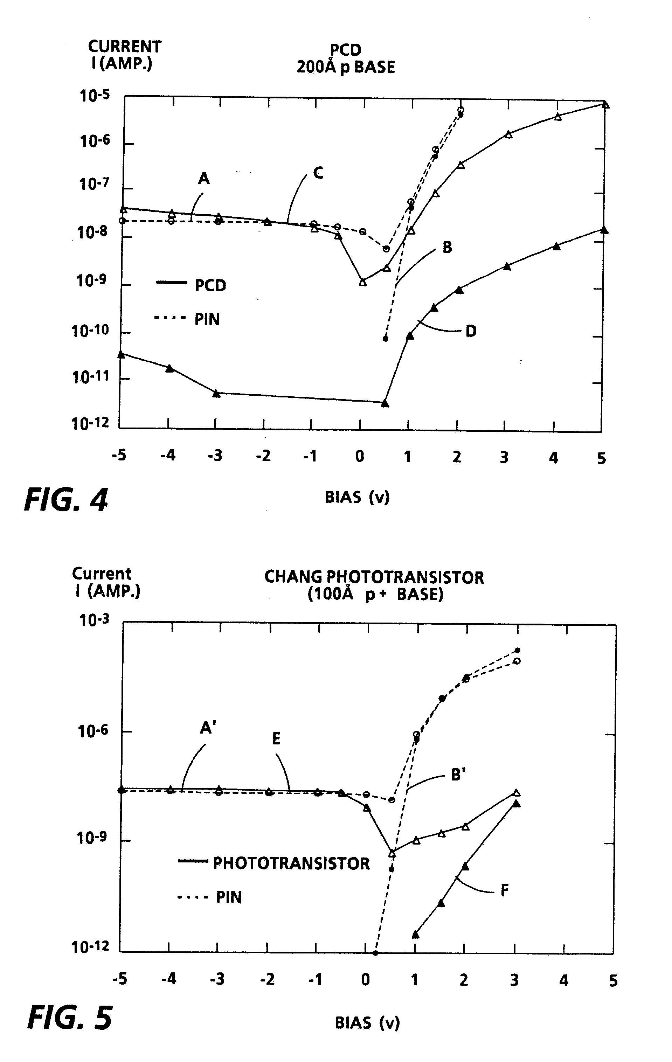

In Figure 4, the I-V characteristics of the side-by-side PCD and p-i-n solar cell are shown. Curve A represents a sample p-i-n solar cell illuminated with a light source of about $10^{15}$ photons/$cm^2$-sec and curve B represents the solar cell in the dark. It is well known that the solar cell exhibits approximately unity gain under reverse bias, i.e., when the device is connected to an external bias circuit with the p layer being negative with respect to the $n^+$ layer. The generally horizontal portion of curve A (at a current somewhat greater that $10^{-8}$ amp) provides a benchmark of unity gain. Under forward bias, i.e., when the positive terminal of an external voltage source is connected to the p layer, the current through the solar cell rises sharply, both in the light and in the dark (curve B). Although a gain greater than unity is obtained under this bias condition, the solar cell does not lend itself to sensor applications in this bias mode because there is no useful light-to-dark sensitivity. Curve C represents a sample PCD sensor, of the present invention, illuminated by the same light source and curve D represents the PCD in the dark. It can be seen that in a reverse bias condition, i.e., when the $n^+$ emitter layer 36 is made negative relative to the $n+$ collector layer 44, only approximately unity gain is achieved. However, under forward bias, i.e., when the $n^+$ emitter layer 36 is made positive relative to the $n^+$ collector layer 44, there is a dramatic increase in gain. For example, at about +3 volts the current (somewhat greater than $10^{-6}$ amp) is about two orders of magnitude (100x) greater than that of the solar cell ($> 10^{-8}$ amp) operating at unity gain. By contrast with the solar cell, at +3 volts the PCD exhibits a very low dark current (somewhat greater than $10^{-9}$ amp). Thus, its light-to-dark sensitivity is about three orders of magnitude (1000x). The characteristics of high gain and excellent light-to-dark sensitivity make the PCD a superior sensor. It is believed that this sensor would have utility at low positive bias, on the order of 1 to 5 volts for the device described.

The I-V characteristics of a side-by-side Chang phototransistor and a p-i-n solar cell are compared in Figure 5. In the sample Chang phototransistor, the $n^+$ emitter and collector layers and both the thin and the thick intrinsic layers were made the same thickness as in the PCD. Only the base layers were different. The lightly doped PCD base layer (p) was 20 nm (200Å) thick and was doped with 1000 ppm boron whereas the heavily doped Chang phototransistor base layer ($p^+$) was 10 nm (100Å) thick and was doped with forty times the boron, i.e. 40,000 ppm, in accordance with the teachings of the Chang *et al* article. It was determined that because of the very heavy doping of the $p^+$ base layer, the operating characteristics of the Chang phototransistor would suffer unduly if the layer were made 10 nm (100Å) thick as taught by Chang.

Curves A′ and B′ (Figure 5) again represent p-i-n solar cell characteristics substantially identical to the solar cell of Figure 4. Output differences are attributable to the differences in the base layer. The Chang phototransistor's operating characteristics are plotted in curves E (light) and F (dark). When illuminated, by the same light source as above, the phototransistor never exhibits a gain above unity either under forward or reverse bias. The benchmark for unity gain is the horizontal current output level of the reverse biased p-i-n solar cell (curve A′). Under forward bias, wherein the $n^+$ emitter layer (26) is made positive with respect to the collector layer (16, 18), current through the sensor rises both in the light and in the dark. It should be noted that the dark current rises at a faster rate. Therefore, it can be concluded that when a significant gain level is achieved, this sensor would exhibit no useful light-to-dark sensitivity.

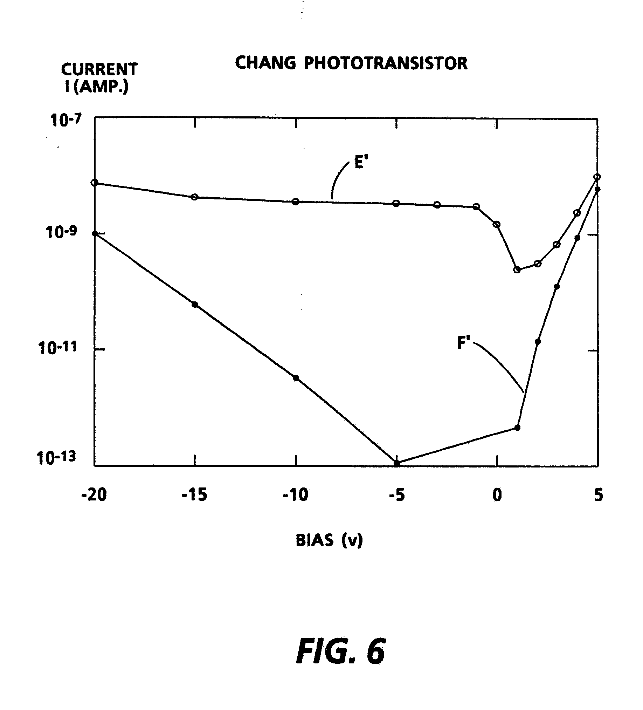

Since the Chang articles asserted that gain is observed only under reverse bias operating conditions, large negative voltages were applied and are shown in Figure 6. A different curve is plotted, since a different sample was used. Curve E′ can be seen to start rising over unity gain at -20 volts. For the device having an overall thickness of about 700 nm this condition approaches breakdown and is therefore not useful. It is expected that it will rise somewhat higher as the reverse bias increases. It should be noted again that the dark current, curve F′ rises at an even faster rate. From this experimental evidence, confirmed by computer simulations, it can only be concluded that the Chang phototransistor is an unsatisfactory sensor as it does not provide high gain together with good light-to-dark sensitivity.

It is well known that p-i-n solar cells provide only primary photocurrent, meaning that the total current output is due solely to the light absorbed by the photosensitive material. In other words, one photon impinging upon the material will produce one electron and one hole and each will flow to its respective electrode, at which time the current ceases to flow, since the electrodes are blocking. In an n-i-n sensor, photoconductive gain is obtained primarily from secondary photocurrent, meaning that current flows through the device and its external circuit many times, with the number of transits of the conducting carrier across the device defined as its gain. While it is true that light impinging on the device creates electron-hole pairs in the intrinsic layer, the great bulk of charge carriers are injected from the external circuit and the light only modifies the current by making the intrinsic layer more conductive. It should be noted that the external bias also increases the dark current. Transport of the charge carriers continues until they recombine and are extinguished as free charges. Therefore, in order to have plural transits across the device, the presence of barriers or localized states should be minimized.

However, as barriers are needed to suppress dark current, the challenge is to provide one or more barrier layers sufficient to suppress dark current but not large enough to diminish light current (i.e., gain). The Chang phototransistor incorporates a heavily doped $p^+$ base layer to establish a high internal barrier, and the emitter is made more negative than the collector. Such a normal operating mode forward biases the emitter/thin intrinsic/base $p^+$-i-n portion of the device, so as to reduce that internal barrier, and reverse biases the collector/thick intrinsic/base $p^+$-i-n portion, so as to increase that internal barrier. Electron lifetime in a heavily doped $p^+$ layer is very short because the $p^+$ layer is very defective and the electrons cannot cross it easily without recombining. Therefore, both dark current and light current are suppressed (as illustrated in Figures 5 and 6), rendering the Chang phototransistor impractical as a sensor.

By contrast, the PCD base layer is lightly doped, and the emitter is made more positive than the collector. This normal operating mode reverse biases the emitter/thin intrinsic/base p-i-n portion of the device and forward biases the collector/thick intrinsic/base p- i-n portion. It is well known that under reverse bias the photovoltaic mode of photocurrent is expected, while under forward bias, the photoconductive mode is prevalent. Thus, in the PCD under normal operating conditions, photoconductive current flow is enhanced through its collector/thick intrinsic/base p-i-n portion, while simultaneously there is less opportunity for carrier losses by recombination in the lightly doped p layer.

**EXAMPLE:** The PCD thin film sensor has been made by the standard PECVD (plasma enhanced chemical vapor deposition) method by which doped and undoped device grade amorphous silicon layers may be deposited. A glass substrate was provided as the support for a conductive layer of chromium, upon which was deposited sequentially: a 10nm to 50 nm layer of $n^+$-type amorphous silicon by the decomposition of 99% silane and 1% phosphine (10,000ppm); a 30 nm layer of intrinsic amorphous silicon, formed from the decomposition of silane; a 20 nm layer of lightly doped, p-type amorphous silicon, formed from the decomposition of silane and 0.1% diborane (1000ppm); a 100 nm to 1 micron layer of intrinsic amorphous silicon; another 10 nm of $n^+$ amorphous silicon; and, finally, a conductive transparent layer of ITO, for optically coupling the silicon to the air.

As described above, the barrier can be adjusted by increasing the doping or increasing the thickness of the p-type layer. The effect of these increases is to introduce defects which hinder electron transport. Therefore, when providing the barrier, a balance must be struck between the desired formation of a potential barrier to the dark current and the undesired reduction of optical gain. Although the description has focussed upon the utilization of a single barrier layer, it has been confirmed by computer simulations that multiple blocking layers could be employed and that this approach is more efficient that just using one internal blocking layer. For example, two blocking layers of a given thickness placed within the PCD, but spatially separated, are more effective at suppressing the dark current than one layer of double their thickness, while still preserving optical gain. This approach can be extended further so that three or more blocking layers may be used to improve the light to dark sensitivity of the sensor.

A sensor having two blocking layers was modelled. It had the following configuration: a 10 nm $n^+$ amorphous silicon layer; a 30 nm intrinsic amorphous silicon layer; a 10 nm p layer; a 400 nm intrinsic amorphous silicon layer; another 10 nm p layer, a 100 nm intrinsic amorphous silicon layer; and 10 nm $n^+$ amorphous silicon layer. In other words, the thick intrinsic region of 500 nm was split into two regions with two p-type barrier layers (cumulatively 20 nm). The effect of the barrier, in terms of dark current suppression, was that of a single layer 40 nm thick. But since there is less p material in the path of the charge carriers to cause recombination losses, there is less effect on the device gain.

It should be understood that the present disclosure has been made only by was of example. For instance, it is contemplated that the barrier layer may be doped or undoped wide or narrow band gap alloys such as photoconductive SiC, SiN or SiGe forming a heterojuntion barrier layer, and may be polycrystalline or microcrystalline. Other changes in details of construction and in materials used may be resorted to

## Claims

1. A multilayer thin film sensor comprising a pair of injecting contact semiconductor layers (36, 44) sandwiching plural intrinsic semiconductor layers (38, 42) characterised by barrier means (40) means therein for suppressing dark current flow and allowing light current flow so that said sensor exhibits a photoelectric gain greater than 3 and a corresponding light-to-dark ratio greater than 30 to 1.

2. The multilayer thin film sensor as defined in claim 1 wherein said injecting contacts (36, 44) are $n^+$-type.

3. The multilayer thin film sensor as defined in claim 1 comprising an $n^+$-type semiconductor emitter layer (36) and an $n^+$-type semiconductor collector layer (44) sandwiching p-type semiconductor barrier means (40), said barrier means being located between a pair of intrinsic semiconductor layers (38, 42), wherein a first of said intrinsic semiconductor layers (38) is thinner than a second of said intrinsic semiconductor layers (42), said first layer (38) is disposed between said emitter layer (36) and said barrier means (40) and said second layer (42) is disposed between said collector layer (44) and said barrier means (40), and said sensor exhibits a photoelectric gain greater than 3 and a corresponding light-to-dark ratio of greater than 30 to 1 when said collector layer (44) is biased negatively with respect to said emitter layer (36).

4. The multilayer thin film sensor as defined in any one of claims 1 to 3 wherein said intrinsic semiconductor layers (38, 42) are amorphous silicon.

5. The multilayer thin film sensor as defined in any one of claims 1 to 4 wherein said barrier means (40) comprises a single lightly doped p-type semiconductor layer.

6. The multilayer thin film sensor as defined in claim 5 wherein said p-type layer is doped to about 1000 ppm.

7. The multilayer thin film sensor as defined in any one of claims 1 to 4 wherein said barrier means (40) comprises a pair of spaced p-type semiconductor layers.

8. The multilayer thin film sensor as defined in any one of claims 1 to 7 wherein said barrier means (40) is photoconductive SiC, SiN or SiGe.

9. A thin film sensor as defined in claim 1 wherein said barrier means (40) comprises a lightly doped p-type semiconductor layer positioned (40) between intrinsic semiconductor layers (38, 42) of different thicknesses, the intrinsic layers being positioned between $n^+$-type semiconductor layers (36, 44), said sensor exhibiting a photoelectric gain greater than 3 and a corresponding light-to-dark ratio of greater than 30 to 1 when said thin $n^+$-i-p portion (36, 38, 40) is reversed biased and said thick $n^+$-i-p portion (44, 42 40) is forward biased.

10. The multilayer thin film sensor as defined in claim 9 wherein said p-type layer is doped to about 1000 ppm.

EP 0 310 353 A2

FIG. 1
PRIOR ART

FIG. 2

FIG. 3

FIG. 4

FIG. 5

FIG. 6